# EUROPEAN PATENT SPECIFICATION

(11) **EP 3 957 619 B1**
(45) Date of publication and mention of the grant of the patent: **12.11.2025**
(21) Application number: 21191666.3
(22) Date of filing: 17.08.2021
(51) Int. Cl.: C04B 35/571, C04B 35/628, C04B 35/80, C04B 35/573, C23C 16/34, C23C 16/36

(54) **METHOD OF MAKING A CERAMIC MATRIX COMPOSITE THAT EXHIBITS CHEMICAL RESISTANCE**
VERFAHREN ZUR HERSTELLUNG EINES KERAMIKMATRIXVERBUNDES MIT CHEMISCHER BESTÄNDIGKEIT
PROCÉDÉ DE FABRICATION D'UN COMPOSITE À MATRICE CÉRAMIQUE PRÉSENTANT UNE RÉSISTANCE CHIMIQUE

(30) Priority: 19.08.2020 US 202063067449 P
(43) Date of publication of application: 23.02.2022
(73) Proprietor: Rolls-Royce High Temperature Composites Inc, Cypress, CA 90630 (US)
(72) Inventor: SHIM, Sungbo, Irvine, 92620 (US); KIDD, Richard, Rancho Palos Verdes, 90275 (US); KRANJC, Kelly, Irvine, 92612 (US); SHINAVSKI, Robert, Mission Viejo, 92691 (US)
(74) Representative: Pfenning, Meinig & Partner mbB

(56) References cited:
- EP-A1- 1 640 352
- US-A- 5 234 609
- US-A- 5 593 728
- US-A1- 2006 147 688
- US-A1- 2014 272 373
- LE GALLET S ET AL: "Microstructural and microtextural investigations of boron nitride deposited from BCl"3-NH"3-H"2 gas mixtures", JOURNAL OF THE EUROPEAN CERAMIC SOCIETY, ELSEVIER, AMSTERDAM, NL, vol. 24, no. 1, 1 January 2004 (2004-01-01), pages 33 - 44, XP004452654, ISSN: 0955-2219, DOI: 10.1016/S0955-2219(03)00126-2

## Description

### TECHNICAL FIELD

The present disclosure relates generally to the fabrication of ceramic matrix composites (CMCs) and more particularly to fabricating a CMC which is resistant to chemical attack and environmental degradation while also exhibiting good mechanical properties.

### BACKGROUND

Ceramic matrix composites, which include ceramic fibers embedded in a ceramic matrix, exhibit a combination of properties that make them promising candidates for industrial applications, such as gas turbine engines, that demand excellent thermal and mechanical properties along with low weight. A ceramic matrix composite that includes a silicon carbide matrix reinforced with silicon carbide fibers may be referred to as a silicon carbide/silicon carbide composite or SiC/SiC composite. Fabrication of a SiC/SiC composite may include slurry and melt infiltration steps to densify a silicon carbide fiber preform. Prior to the infiltration steps, the fibers making up the silicon carbide preform may be coated with one or more materials to protect the fibers and/or improve the performance of the final densified composite.

EP 1 640 352 A1 discloses a method for manufacturing a ceramic matrix composite article. The method includes providing a plurality of ceramic fiber tows. The method further includes depositing a coating comprising a layer of boron nitride, a layer of silicon-doped boron nitride, a layer of silicon nitride, and a layer of carbon. The method further includes assembling the coated fiber tows into a plurality of plies of ceramic cloth. The method further includes laying up the plies of ceramic cloth into an article form. The method further includes densifying the article form using a material selected from the group consisting of ceramic particulates, ceramic precursor resins, and combinations thereof and using a method selected from the group consisting of slurry casting, resin transfer molding, vacuum impregnation, and combinations thereof. The method further includes infiltrating the article form with at least silicon to form a ceramic matrix composite article with a substantially continuous matrix.

US 2014/272373 A1 describes a ceramic matrix composite having improved operating characteristics which includes a barrier layer.

Le Gallet et al. describe in J. Eur. Chem. Soc. Vol. 24, 2004, 33-44 microstructural and microtextural investigations of boron nitride deposited from BCl₃-NH₃-H₂ gas mixtures.

US 5 234 609 A discloses an X-ray-permeable membrane for X-ray lithographic mask for fine patterning in the manufacture of semiconductor devices having good transparency to visible light and exhibiting excellent resistance against high-energy beam irradiation. The membrane has a chemical composition expressed by the formula SiCxNy and can be prepared by the thermal CVD method in an atmosphere of a gaseous mixture consisting of gases comprising, as a group, the elements of silicon, carbon and nitrogen such as a ternary combination of silane, propane and ammonia.

US 5 593 728 A describes an improved interface coating for a fibrous material composed of a silicon-containing boron nitride having the general composition BSiₓN_{1+1.33x}, and containing from 2 wt % to 42 wt % of silicon, with substantially no free silicon present. The coating is formed by CVD using reactant vapors of ammonia and a gaseous source of both boron and silicon which flow into the furnace chamber at a controlled flow ratio to nitride the deposit to form the complex coating.

US 2006/147688 A1 discloses a ceramic matrix composite with a ceramic matrix and a gradient layering of coating on ceramic fibers. The coating typically improves the performance of the composite in one direction while degrading it in another direction. For a SiC-SiC ceramic matrix composite, a BN coating is layered in a gradient fashion or in a step-wise fashion in different regions of the article comprising the ceramic. The BN coating thickness is applied over the ceramic fibers to produce varying desired physical properties by varying the coating thickness within differing regions of the composite, thereby tailoring the strength of the composite in the different regions. The coating may be applied as a single layer as a multi-layer coating to enhance the performance of the coating as the ceramic matrix is formed or infiltrated from precursor materials into a preform of the ceramic fibers.

### BRIEF DESCRIPTION OF THE DRAWINGS

The embodiments may be better understood with reference to the following drawing(s) and description. The components in the figures are not necessarily to scale. Moreover, in the figures, like-referenced numerals designate corresponding parts throughout the different views.
FIG. 1 is cross-sectional schematic, not to scale, of a silicon carbide fiber coated with multiple functional layers.
FIG. 2 is a flow chart showing exemplary steps of the method.

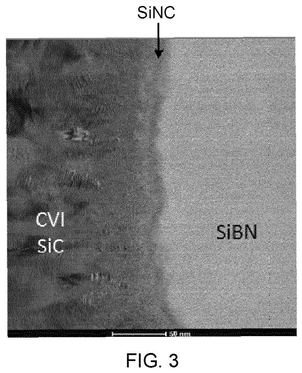

FIG. 3 is a high-resolution transmission electron microscopy (TEM) image providing a cross-sectional view of a portion of a silicon carbide fiber coated with functional layers; scale bar is 50 nm.

### DETAILED DESCRIPTION

A method of making a ceramic matrix composite (CMC) that may show improved resistance to chemical attack from molten silicon along with excellent environmental resistance and mechanical performance is defined in claim 1. The method includes controllably depositing a sequence of coatings or layers, each having a particular function, on silicon carbide fibers that serve as reinforcements in the final CMC. After the layers are applied, a fiber preform comprising the silicon carbide fibers may undergo slurry infiltration and then melt infiltration to form the final CMC.

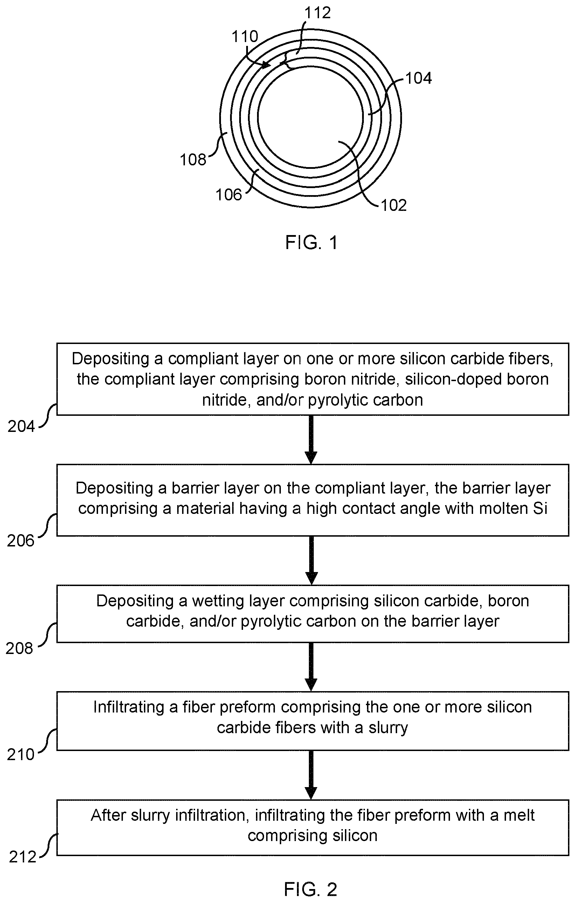

Referring to FIGs. 1 and 2, the method includes depositing 204 a compliant layer 104 comprising boron nitride, silicon-doped boron nitride, and/or pyrolytic carbon on one or more silicon carbide fibers 102, which may be referred to as "the silicon carbide fibers." The compliant layer 104 may help to ensure a weak fiber-matrix interface in the finished CMC and promote matrix crack deflection, thereby improving fracture toughness. A barrier layer 106 comprising a material having a high contact angle with molten silicon is deposited 206 on the compliant layer 110. This barrier layer 106 may resist wetting by molten silicon and thus function as a chemical barrier against silicon attack during melt infiltration. In some examples, as discussed, but not claimed, further below, the barrier layer 106 may have a sufficient thickness to serve as a rigidization layer. The compliant layer 110 has a multilayer structure, as shown in FIG. 1. A wetting layer 108 comprising silicon carbide is deposited 208 on the barrier layer 106. The wetting layer 108 may be readily wet by silicon and thus may promote formation of a porosity-free CMC during melt infiltration and cooling. According to the invention, as discussed further below, the wetting layer has a sufficient thickness to function as the rigidization layer. After depositing 208 the wetting layer 108, a fiber preform comprising the silicon carbide fibers is infiltrated 210 with a slurry, and, after slurry infiltration, the fiber preform is infiltrated 212 with a melt comprising silicon. Upon cooling of the melt, a dense CMC which includes the silicon carbide fibers in a ceramic matrix comprising silicon carbide may be formed.

The unique positioning of the barrier layer 106 between the compliant layer 104 and the wetting and rigidization layer 108 may lead to improvements in the fabrication and properties of the CMC. Previous work has shown that molten silicon can diffuse through a silicon carbide rigidization layer and chemically attack the underlying compliant layer and/or the silicon carbide fibers. In this disclosure, the barrier layer 106 is deposited prior to the rigidization and wetting layer 108 and thus is uniquely positioned to provide a chemical barrier against silicon attack without sacrificing the wettability desired for the wetting layer 108. Each of the layers, which may be referred to as "functional layers," is described below in order of deposition.

First, it is noted that deposition of the functional layers on the silicon carbide fibers may be carried out using chemical vapor infiltration (CVI) methods. Generally speaking, CVI entails flowing gaseous reagents at an elevated temperature through a furnace or reaction chamber containing one or more porous specimens to be coated. The one or more porous specimens may comprise any arrangement of the silicon carbide fibers (*e.g*., a fiber preform and/or fiber tows, as discussed below), where interstices between adjacent silicon carbide fibers may be understood to constitute pores. During CVI, the gaseous reagents may infiltrate the porous specimen(s) (*e.g*., the fiber preform and/or the fiber tows) and chemically react to form a deposit, coating or layer on exposed surfaces of the silicon carbide fibers. The porous specimen(s) may be untooled or constrained with a tool during deposition. A suitable tool may include through-holes for passage of the gaseous reagents and may be formed of a chemically inert and/or refractory material, such as graphite or silicon carbide, which is stable at the elevated temperatures at which deposition takes place. Through-holes in the tool may have a diameter or width sized to allow for a sufficient flow of gaseous reactants into the porous specimen during CVI. The tool may have a single-piece or multi-piece construction suitable for constraining the porous specimen(s) in a desired configuration and for easy removal after deposition of the coatings.

As indicated above, the compliant layer 110 may comprise boron nitride, silicon-doped boron nitride, and/or pyrolytic carbon and may promote good fracture toughness in the finished CMC. Notably, the compliant layer 110 may have a sufficient thickness to prevent thermally-induced cracking of the barrier layer 106, which may have a coefficient of thermal expansion below that of the silicon carbide fibers. To deposit a compliant layer 110 comprising boron nitride (or, in the example of a compliant multilayer 110, an interface layer 104 comprising boron nitride as described below), the silicon carbide fibers 102 may be exposed to a gaseous atmosphere comprising a flow of nitrogen-containing gas, such as ammonia, and a flow of boron-containing gas, such as boron trichloride, at a temperature in a range from about 700°C to about 875°C. The gaseous atmosphere may further comprise a flow of a substantially inert carrier gas such as N₂ or H₂. In one example, the compliant layer 110 may comprise a crystalline (hexagonal) phase of the boron nitride, which is preferred since amorphous or turbostratic boron nitride is more likely to degrade upon exposure to moisture and/or oxygen at elevated temperatures. Crystallinity of the boron nitride may be promoted or ensured by exposure to atmospheric humidity and a heat treatment as described below, which may optionally take place during CVI of a successive layer. To form pyrolytic carbon, which may refer to polycrystalline carbon or graphite formed in a pyrolytic process, the silicon carbide fibers 102 may be exposed to a gaseous atmosphere comprising a flow of a hydrocarbon-containing gas in the same or a similar temperature range.

Since the compliant layer 110 comprises a boron nitride layer, it is beneficial to further deposit on the boron nitride layer, prior to depositing the barrier layer 106, a moisture-tolerant layer 112 that comprises silicon-doped boron nitride. In such a case the compliant layer 110 has a multilayered structure including the moisture-tolerant layer 112 and the boron nitride layer, which may be referred to as an interface layer 104, as illustrated in FIG. 1. Silicon-doped boron nitride may more effectively resist environmental degradation and/or chemical attack from molten silicon than boron nitride. A concentration of silicon in the silicon-doped boron nitride is in a range from about 2 at.% to about 30 at.%. To deposit either a compliant layer 110 or a moisture-tolerant layer 112 comprising silicon-doped boron nitride, a silicon-containing gas may be incorporated into the gaseous atmosphere in addition to the nitrogen-containing gas and the boron-containing gas. Suitable silicon-containing gases may include methyltrichlorosilane (CH₃SiCl₃), trichlorosilane (HSiCl₃), dichlorosilane (H₂SiCl₂), silicon tetrachloride (SiCl₄), and silane (SiH₄). Typically, CVI of silicon-doped boron nitride is carried out at a temperature in a range from about 700°C to about 875°C. The gaseous atmosphere may further comprise a flow of a substantially inert carrier gas such as N₂ or H₂, where H₂ is preferred. It has been found that using H₂ as a carrier gas instead of N₂ may lead to a 50% increase in deposition rate of the silicon-doped boron nitride. Typically, deposition of the moisture-tolerant layer 112 may take place over a time duration of 10-70 hours. The moisture-tolerant layer 112 may have a thickness in a range from about 0.4 micron to about 3 microns. The interface layer 104 may have a thickness in a range from about 0.01 micron to about 0.10 micron and/or from 0.05 micron to about 0.1 micron, and deposition of the interface layer 104 may take place over a time duration of 1-10 hours.

In addition to serving as a compliant release layer, the interface layer 104 may function as a diffusion barrier between residual carbon (sizing) char on the silicon carbide fibers 102 and the moisture-tolerant layer 112. To promote crystallinity of the interface layer 104 (e.g., formation of the hexagonal boron nitride phase) as mentioned above, the method may further include exposing the interface layer 104 and/or the compliant layer 110 to atmospheric humidity, and then heat treating the interface layer 104 and/or the compliant layer 110 at a temperature in a range from about 900°C to about 1150°C, preferably in an inert atmosphere.

The barrier layer 106 that overlies the multilayer compliant layer 110 has a high contact angle with molten silicon, such as a contact angle of at least about 45°, so as to serve as an effective chemical barrier. Accordingly, the barrier layer 106 comprises silicon nitride or silicon nitrocarbide, such as SiₓN_{y}C_{z}, both of which may exhibit the requisite contact angle with molten silicon. In one example, 0.1 < x < 0.697, 0.3 < y < 0.6, and 0.003 < z < 0.33; that is, the barrier layer 106 may include carbon at a concentration from about 0.3 at.% to 33 at.% and nitrogen at a concentration from about 30 at.% to 60 at.%, with a balance of silicon and any incidental inpurities. Silicon nitrocarbide may be understood to comprise a mixture of silicon carbide (SiC), silicon nitride (Si₃N₄), and/or carbon (C). The silicon nitrocarbide may be amorphous and may remain amorphous during CVI processing due at least in part to the presence of carbon, which may inhibit or prevent crystallization. Consequently, crystallization-induced shrinkage cracking of the barrier layer 106, a problem that can be associated with amorphous silicon nitride, which does not include any appreciable amount of carbon, may be beneficially avoided. If the barrier layer 106 comprises silicon nitride (*e.g*., Si₃N₄), crystalline silicon nitride is preferred, and more particularly crystalline silicon nitride which is devoid of cracks. As indicated above, the crack resistance of the barrier layer 106 may be enhanced when the underlying compliant layer 110 has suitable thickness, such as from about 0.5 micron to about 3 microns. The barrier layer 106 may be deposited to have a thickness in a range from about 0.005 micron to about 2 micron, or more preferably in a range from about 0.5 micron to about 2 micron, when the barrier layer is intended to serve as a rigidization layer, which is outside of the scope of the invention. In such a case, outside of the scope of the invention, the wetting layer may be fairly thin, with a thickness in a range from about 0.01 micron to about 0.5 micron or more typically from about 0.01 micron to about 0.1 micron.

Deposition of the barrier layer 106 on the compliant layer 110 may comprise exposing the compliant layer 110 to a gaseous atmosphere comprising a flow of a silicon-containing gas and a flow of a nitrogen-containing gas, as described above, at a temperature in a range from about 700°C to about 1000°C. The method may further include, when the compliant layer 110 comprises boron nitride or silicon-doped boron nitride, halting the flow of the boron-containing gas into the gaseous atmosphere, while the nitrogen- and/or silicon-containing gases continue to flow. It may be beneficial to halt the flow of the boron-containing gas for 5-30 minutes before the flows of the nitrogen- and silicon-containing gases are halted. If the intent is to deposit a barrier layer 106 comprising silicon nitrocarbide, instead of silicon nitride, then a flow of a carbon-containing gas may be included in the gaseous atmosphere. The carbon-containing gas may be the same as or different from the silicon-containing gas or the nitrogen-containing gas. In other words, the silicon-containing gas or the nitrogen-containing gas may also include carbon. One example of a silicon-containing gas that includes carbon is methyltrichlorosilane (CH₃SiCl₃), as mentioned above, which is also known as MTS. In addition to the silicon-, nitrogen- and/or carbon-containing gases, which may individually or collectively be referred to as reactive gas(es), the gaseous atmosphere may further include a flow of a carrier gas, which as indicated above may be a nonreactive gas that does not participate in the CVI reaction, and which may be selected from N₂ and H₂.

After deposition of the barrier layer 106, the wetting layer 108 may be deposited. According to the invention, the wetting layer 108 comprises silicon carbide. Deposition may entail CVI utilizing a flow of a silicon-containing gas that further contains carbon, such as the MTS mentioned above. Prior to CVI of the wetting layer, the flow of all gases except the carrier gas (*e.g*., H₂ or N₂) may be halted and the furnace may be cooled. According to the invention, silicon carbide is selected for the wetting layer 108, and the thickness of the wetting layer 108 lies in a range from about 0.5 micron to about 10 microns, then the wetting layer 108 is able to provide a rigidization function in addition to a wetting function. According to the invention, the barrier layer 106 is fairly thin, with a thickness in a range from about 0.005 micron to about 0.5 micron or more typically from about 0.005 micron to about 0.1 micron. CVI of the wetting layer 108 may be carried out from about 1 hour to about 60 hours, and generally at a temperature in a range from about 600°C to about 1500°C.

The silicon carbide fibers 102 that undergo coating may be arranged in a fiber tow, unidimensional tape, braid, ply, and/or woven fabric (e.g., 2D woven, 3D woven and/or 2.5D woven), and may further be part of a fiber preform that has a predetermined shape, such as an airfoil shape. The fiber preform is typically produced in a lay-up process from the plies, woven fabrics and/or tapes and may be described as a three-dimensional framework of the silicon carbide fibers or fiber tows. Typically, the silicon carbide fibers are assembled into a fiber preform prior to CVI.

After deposition of the functional layers, the silicon carbide fibers may be referred to as coated silicon carbide fibers, and the fiber preform may be referred to as a rigidized preform. Deposition of the functional layers may be followed by slurry infiltration to impregnate the rigidized preform with matrix precursors, forming what may be referred to as an impregnated fiber preform. A suitable slurry may include ceramic (*e.g.,* silicon carbide) particles and/or particulate reactive elements (*e.g.,* elements reactive with molten silicon or a molten silicon alloy), such as carbon, in an aqueous or organic liquid. The slurry may further include a carbonaceous resin, such as phenolic or furfuryl alcohol. In some cases, the carbonaceous resin may be separately infiltrated into the rigidized preform after slurry infiltration, or may not be used at all. If a carbonaceous resin is employed, one or more additional steps, such as curing and/or pyrolysis, may be carried out to convert the resin to carbon. Typically, the impregnated fiber preform comprises a loading level of particulate matter, including ceramic particles and particulate reactive elements, from about 40 vol.% to about 60 vol.%, with the remainder being porosity. The method may further comprise infiltrating the fiber preform with molten material (*e.g*., molten silicon or a molten silicon alloy) followed by cooling to form a densified ceramic matrix composite. Due to the presence of the barrier coating, the silicon carbide fibers and the compliant layer (or interface multilayer) may be protected from attack by molten silicon.

During melt infiltration, the molten material infiltrated into the rigidized and/or impregnated fiber preform may consist essentially of silicon (*e.g*., elemental silicon and any incidental impurities) or may comprise a silicon-rich alloy. Melt infiltration may be carried out at a temperature at or above the melting temperature of silicon or the silicon alloy which is infiltrated. Thus, the temperature for melt infiltration is typically in a range from about 1380°C to about 1700°C. In one example, a ramp rate from an intermediate temperature of about 800°C to a temperature above about 1380°C may be less than about 10°C/min. A suitable time duration for melt infiltration may be from 15 minutes to four hours, depending in part on the size and complexity of the ceramic matrix composite to be formed. A ceramic matrix is formed from ceramic particles as well as ceramic reaction products created from reactions between the molten material and any other particles (e.g., carbon particles, refractory metal particles) in the fiber preform. Preferably, the final ceramic matrix composite is substantially devoid of closed porosity. In some cases, the ceramic matrix composite may form part or all of a gas turbine engine component, such as a blade or vane.

### EXAMPLE

5HS Hi-Nicalon Type S fabric is preformed into a 16.5 cm x 17.8 cm x 0.508 cm (6.5" x 7" x 0.200") panel, tooled into a graphite tool with diffusion holes, and loaded in a furnace. After evacuation, the furnace is heated to 1000°C for 5 mins to 1 hour for heat treatment of the panel/fiber preform. The furnace temperature is then cooled to 750 to 850°C and flows of N₂, BCl₃, and NH₃ are introduced for three hours to apply a compliant layer comprising boron nitride on the silicon nitride fibers of the preform. Next, a flow of MTS is added to the gaseous atmosphere for 25 to 40 hours, and a moisture tolerant layer comprising silicon-doped boron nitride is deposited on the compliant layer, forming an interface multilayer. In a next step, the BCl₃ is shut off for 15 minutes while the flows of MTS, NH₃ and N₂ continue to form silicon nitrocarbide. Finally, the flow of all gases except N₂ are halted and the furnace is cooled. Subsequently, a SiC layer is deposited to form a rigidization or wetting layer. The preform may be slurry infiltrated with a SiC-containing slurry followed by melt infiltration with silicon or a silicon alloy to form a SiC/SiC composite.

The microstructure of the functional coatings on the silicon carbide fiber is revealed with transmission electron microscopy (TEM) in conjunction with an electron energy loss spectroscopy (EELS) line scan that shows element profiles. Spikes of nitrogen and silicon with a trace of carbon are observed between the silicon carbide wetting layer and the silicon-doped boron nitride moisture-tolerant layer, revealing the presence of the silicon nitrocarbide (SiNC) barrier layer. A high resolution transmission electron microscopy (TEM) image shown in FIG. 2 reveals a distinctive barrier layer comprising silicon nitrocarbide between the SiC wetting layer and the Si-doped BN moisture tolerant layer. Previous internal development work has demonstrated that a SiNC barrier layer overcoated with a SiC wetting layer of about 0.5 micron in thickness can be effective in protecting the underlying compliant layer/interface multilayer and the silicon carbide fibers.

To clarify the use of and to hereby provide notice to the public, the phrases "at least one of <A>, <B>, ... and <N>" or "at least one of <A>, <B>, ... <N>, or combinations thereof" or "<A>, <B>, ... and/or <N>" are defined by the Applicant in the broadest sense, superseding any other implied definitions hereinbefore or hereinafter unless expressly asserted by the Applicant to the contrary, to mean one or more elements selected from the group comprising A, B, ... and N. In other words, the phrases mean any combination of one or more of the elements A, B, ... or N including any one element alone or the one element in combination with one or more of the other elements which may also include, in combination, additional elements not listed. Unless otherwise indicated or the context suggests otherwise, as used herein, "a" or "an" means "at least one" or "one or more."

While various embodiments have been described, it will be apparent to those of ordinary skill in the art that many more embodiments and implementations are possible. Accordingly, the embodiments described herein are examples, not the only possible embodiments and implementations.

## Claims

1. A method of making a ceramic matrix composite that exhibits chemical resistance, the method comprising:
depositing (204) a compliant layer (104, 110) comprising boron nitride, silicon-doped boron nitride, and/or pyrolytic carbon on silicon carbide fibers (102);
depositing (206) a barrier layer (106) having a high contact angle with molten silicon on the compliant layer (104, 110), the barrier layer (106) having a thickness in a range from about 0.005 micron to about 0.5 micron and the barrier layer (106) comprises silicon nitrocarbide or silicon nitride;
depositing (208) a wetting layer (108) comprising silicon carbide on the barrier layer (106), the wetting layer (108) having a thickness in a range from 0.5 micron to about 10 microns, wherein the wetting layer (108) serves as a rigidization layer;
after depositing the wetting layer (108), infiltrating (210) a fiber preform comprising the silicon carbide fibers (102) with a slurry;
wherein the compliant layer (104, 110) includes a boron nitride layer,
further comprising depositing a moisture-tolerant layer (112) comprising silicon-doped boron nitride on the boron nitride layer prior to depositing the barrier layer (106), the boron nitride layer being an interface layer (104), the compliant layer (104, 110) thereby comprising a multilayer structure including the moisture-tolerant layer (112) and the interface layer (104),
wherein the moisture-tolerant layer (112) includes silicon at a concentration of from about 2 at. % to about 30 at. %, and
after infiltration with the slurry, infiltrating (212) the fiber preform with a melt comprising silicon and then cooling the melt, thereby forming a ceramic matrix composite.

2. The method of claim 1, wherein the barrier layer (106) comprises amorphous silicon nitrocarbide.

3. The method of claim 2, wherein the silicon nitrocarbide includes carbon at a concentration from about 0.3 at. % to 33 at. % and nitrogen at a concentration from about 30 at. % to 60 at. %.

4. The method of any one of the preceding claims, wherein a thickness of the compliant layer (104, 110) lies in a range from about 0.5 micron to about 3 microns and/or the barrier layer (106) has a coefficient of thermal expansion lower than that of the silicon carbide fibers (102).

5. The method of any one of the preceding claims, wherein depositing (206) the barrier layer (106) on the compliant layer (104, 110) comprises exposing the compliant layer (104, 110) to a gaseous atmosphere comprising:
a flow of a carrier gas selected from N₂ and H₂,
a flow of silicon-containing gas, wherein the silicon-containing gas preferably further comprises carbon, especially preferred the silicon-containing gas comprises methyltrichlorosilane (CH₃SiCl₃) and
a flow of a nitrogen-containing gas, wherein preferably the nitrogen-containing gas comprises ammonia, at a temperature in a range from about 700°C to about 1000°C.

6. The method of any one of the preceding claims, a thickness of the moisture-tolerant layer (112) is from about 3 to about 300 times a thickness of the interface layer (104), and/or the compliant layer (104, 110) comprises a crystalline phase of the boron nitride.

7. The method of any one of the preceding claim, wherein depositing the interface layer (104) comprises exposing the silicon carbide fibers (102) to a gaseous atmosphere comprising:
a flow of a carrier gas selected from N₂ and H₂,
a flow of a nitrogen-containing gas, and a flow of a boron-containing gas at a temperature in a range from about 700°C to about 875°C, and
wherein depositing the moisture-tolerant layer (112) comprises introducing a flow of silicon-containing gas into the gaseous atmosphere after depositing the interface layer (104).

8. The method of any one of the preceding claims further comprising forming the fiber preform prior to coating the silicon carbide fibers (102) with the compliant layer (104, 110).

9. A fiber preform for fabricating a ceramic matrix composite, the fiber preform comprising:
silicon carbide fibers (102) coated with a plurality of functional layers, the functional layers including:
a compliant layer (104, 110) comprising boron nitride, silicon-doped boron nitride, and/or pyrolytic carbon deposited on the silicon carbide fibers (102);
a barrier layer (106) having a high contact angle with molten silicon deposited on the compliant layer (104, 110), the barrier layer (106) having a thickness in a range from about 0.005 micron to about 0.5 micron, wherein the barrier layer (106) comprises silicon nitrocarbide or silicon nitride;
a wetting layer (108) comprising silicon carbide deposited on the barrier layer (106), the wetting layer (108) having a thickness in a range from 0.5 micron to about 10 microns, wherein the wetting layer (108) serves as a rigidization layer;
wherein the compliant layer (104, 110) includes a boron nitride layer,
a moisture-tolerant layer (112) comprising silicon-doped boron nitride on the boron nitride layer, the boron nitride layer being an interface layer (104), the compliant layer (104, 110) thereby comprising a multilayer structure including the moisture-tolerant layer (112) and the interface layer (104),
wherein the moisture-tolerant layer (112) includes silicon at a concentration of from about 2 at. % to about 30 at. %.

10. The fiber preform of claim 9, wherein the silicon nitrocarbide includes carbon at a concentration from about 0.3 at.% to 33 at. % and nitrogen at a concentration from about 30 at. % to 60 at. %.

11. The fiber preform of any one of claims 9 to 10, wherein a thickness of the compliant layer (104, 110) lies in a range from about 0.5 micron to about 3 microns and/or the barrier layer (106) has a coefficient of thermal expansion lower than that of the silicon carbide fibers (102).

## Patentansprüche

1. Verfahren zur Herstellung eines Keramikmatrixverbundwerkstoffes, der chemische Beständigkeit zeigt, wobei das Verfahren umfasst:
Abscheiden (204) einer Ausgleichsschicht (104, 110), die Bornitrid, siliziumdotiertes Bornitrid und/oder pyrolytischen Kohlenstoff umfasst, auf Siliziumkarbidfasern (102);
Abscheiden (206) einer Sperrschicht (106), die einem hohen Kontaktwinkel mit geschmolzenem Silizium aufweist, auf der Ausgleichsschicht (104, 110), wobei die Sperrschicht (106) eine Dicke in einem Bereich von etwa 0,005 Mikrometer bis etwa 0,5 Mikrometer aufweist und die Sperrschicht (106) Siliziumnitrokarbid oder Siliziumnitrid umfasst;
Abscheiden (208) einer Benetzungsschicht (108), die Siliziumkarbid umfasst, auf der Sperrschicht (106), wobei die Benetzungsschicht (108) eine Dicke in einem Bereich von 0,5 Mikrometer bis etwa 10 Mikrometer aufweist, wobei die Benetzungsschicht (108) als Versteifungsschicht dient;
nach dem Aufbringen der Benetzungsschicht (108), Infiltrieren (210) einer die Siliziumkarbidfasern (102) umfassenden Faservorform mit einer Suspension;
wobei die Ausgleichsschicht (104, 110) eine Bornitridschicht beinhaltet,
des Weiteren umfassend das Abscheiden einer feuchtigkeitstoleranten Schicht (112), die siliziumdotiertes Bornitrid umfasst, auf der Bornitridschicht vor dem Abscheiden der Sperrschicht (106), wobei die Bornitridschicht eine Grenzschicht (104) ist, wobei die Ausgleichsschicht (104, 110) dadurch eine mehrlagige Struktur umfasst, die die feuchtigkeitstolerante Schicht (112) und die Grenzschicht (104) beinhaltet,
wobei die feuchtigkeitstolerante Schicht (112) Silizium in einer Konzentration von etwa 2 Atom- % bis etwa 30 Atom- % beinhaltet, und
nach der Infiltration mit der Suspension, Infiltrieren (212) der Faservorform mit einer Silizium umfassenden Schmelze und anschließendes Abkühlen der Schmelze, wodurch ein Keramikmatrixverbundwerkstoff gebildet wird.

2. Verfahren nach Anspruch 1, wobei die Sperrschicht (106) amorphes Siliziumnitrokarbid umfasst.

3. Verfahren nach Anspruch 2, wobei das Siliziumnitrokarbid Kohlenstoff in einer Konzentration von etwa 0,3 Atom- % bis 33 Atom- % und Stickstoff in einer Konzentration von etwa 30 Atom- % bis 60 Atom- % beinhaltet.

4. Verfahren nach einem der vorhergehenden Ansprüche, wobei eine Dicke der Ausgleichsschicht (104, 110) in einem Bereich von etwa 0,5 Mikrometer bis etwa 3 Mikrometer liegt und/oder die Sperrschicht (106) einen geringeren Wärmeausdehnungskoeffizienten als die Siliziumkarbidfasern (102) aufweist.

5. Verfahren nach einem der vorhergehenden Ansprüche, wobei das Abscheiden (206) der Sperrschicht (106) auf der Ausgleichsschicht (104, 110) das Aussetzen der Ausgleichsschicht (104, 110) einer Gasatmosphäre umfasst, umfassend:
einen Strom eines Trägergases, ausgewählt aus N₂ und H₂,
einen Strom von siliziumhaltigem Gas, wobei das siliziumhaltige Gas vorzugsweise des Weiteren Kohlenstoff umfasst, wobei das siliziumhaltige Gas besonders bevorzugt Methyltrichlorsilan (CH₃SiCl₃) umfasst und
einen Strom eines stickstoffhaltigen Gases, wobei das stickstoffhaltige Gas vorzugsweise Ammoniak umfasst, bei einer Temperatur in einem Bereich von etwa 700°C bis etwa 1000°C.

6. Verfahren nach einem der vorhergehenden Ansprüche, wobei eine Dicke der feuchtigkeitstoleranten Schicht (112) etwa das 3- bis etwa 300-fache der Dicke der Grenzschicht (104) beträgt und/oder die Ausgleichsschicht (104, 110) eine kristalline Phase des Bornitrids umfasst.

7. Verfahren nach einem der vorhergehenden Ansprüche, wobei das Abscheiden der Grenzschicht (104) das Aussetzen der Siliziumkarbidfasern (102) einer Gasatmosphäre umfasst, umfassend:
einen Strom eines Trägergases, ausgewählt aus N₂ und H₂,
einen Strom eines stickstoffhaltigen Gases und einen Strom eines borhaltigen Gases bei einer Temperatur im Bereich von etwa 700°C bis etwa 875°C, und
wobei das Abscheiden der feuchtigkeitstoleranten Schicht (112) das Einleiten eines Stroms von siliziumhaltigem Gas in die Gasatmosphäre nach dem Abscheiden der Grenzschicht (104) umfasst.

8. Verfahren nach einem der vorhergehenden Ansprüche, des Weiteren umfassend das Bilden der Faservorform vor dem Beschichten der Siliziumkarbidfasern (102) mit der Ausgleichsschicht (104, 110).

9. Faservorform zur Herstellung eines Keramikmatrixverbundwerkstoffes, wobei die Faservorform Folgendes umfasst:
Siliziumkarbidfasern (102), die mit einer Vielzahl von Funktionsschichten beschichtet sind, wobei die Funktionsschichten Folgendes beinhalten:
eine Ausgleichsschicht (104, 110), die Bornitrid, siliziumdotiertes Bornitrid und/oder pyrolytischen Kohlenstoff umfasst, abgeschieden auf die Siliziumkarbidfasern (102);
eine Sperrschicht (106), die einen hohen Kontaktwinkel mit geschmolzenem Silizium aufweist, abgeschieden auf der Ausgleichsschicht (104, 110), wobei die Sperrschicht (106) eine Dicke in einem Bereich von etwa 0,005 Mikrometer bis etwa 0,5 Mikrometer aufweist, wobei die Sperrschicht (106) Siliziumnitrokarbid oder Siliziumnitrid umfasst;
eine Benetzungsschicht (108), die Siliziumkarbid umfasst, abgeschieden auf der Sperrschicht (106), wobei die Benetzungsschicht (108) eine Dicke in einem Bereich von 0,5 Mikrometer bis etwa 10 Mikrometer aufweist, wobei die Benetzungsschicht (108) als Versteifungsschicht dient;
wobei die Ausgleichsschicht (104, 110) eine Bornitridschicht beinhaltet,
eine feuchtigkeitstolerante Schicht (112), die siliziumdotiertes Bornitrid auf der Bornitridschicht umfasst, wobei die Bornitridschicht eine Grenzschicht (104) ist, wodurch die Ausgleichsschicht (104, 110) eine mehrlagige Struktur umfasst, die die feuchtigkeitstolerante Schicht (112) und die Grenzschicht (104) beinhaltet,
wobei die feuchtigkeitstolerante Schicht (112) Silizium in einer Konzentration von etwa 2 Atom- % bis etwa 30 Atom- % beinhaltet.

10. Faservorform nach Anspruch 9, wobei das Siliziumnitrokarbid Kohlenstoff in einer Konzentration von etwa 0,3 Atom-% bis 33 Atom- % und Stickstoff in einer Konzentration von etwa 30 Atom- % bis 60 Atom- % beinhaltet.

11. Faservorform nach einem der Ansprüche 9 bis 10, Wobei eine Dicke der Ausgleichsschicht (104, 110) in einem Bereich von etwa 0,5 Mikrometer bis etwa 3 Mikrometer liegt und/oder die Sperrschicht (106) einen geringeren Wärmeausdehnungskoeffizienten als die Siliziumkarbidfasern (102) aufweist.

## Revendications

1. Procédé de fabrication d'un composite à matrice céramique qui affiche une résistance chimique, le procédé comprenant :
le dépôt (204) d'une couche souple (104, 110) comprenant du nitrure de bore, du nitrure de bore dopé au silicium et/ou du carbone pyrolytique sur des fibres de carbure de silicium (102) ;
le dépôt (206) d'une couche barrière (106) ayant un angle de contact élevé avec le silicium fondu sur la couche souple (104, 110), la couche barrière (106) ayant une épaisseur comprise entre environ 0,005 micron et environ 0,5 micron et la couche barrière (106) comprend du nitrocarbure de silicium ou du nitrure de silicium ;
le dépôt (208) d'une couche de mouillage (108) comprenant du carbure de silicium sur la couche barrière (106), la couche de mouillage (108) ayant une épaisseur comprise entre 0,5 micron et environ 10 microns, dans lequel la couche de mouillage (108) sert de couche de rigi-dification ;
après dépôt de la couche de mouillage (108), l'infiltration (210) d'une préforme de fibres comprenant les fibres de carbure de silicium (102) avec une boue ;
dans lequel la couche souple (104, 110) comporte une couche de nitrure de bore,
comprenant en outre le dépôt d'une couche tolérante à l'humidité (112) comprenant du nitrure de bore dopé au silicium sur la couche de nitrure de bore avant le dépôt de la couche barrière (106), la couche de nitrure de bore étant une couche d'interface (104), la couche souple (104, 110) comprenant ainsi une structure multicouche comportant la couche tolérante à l'humidité (112) et la couche d'interface (104),
dans lequel la couche tolérante à l'humidité (112) comporte du silicium à une concentration d'environ 2 % atomique à environ 30 % atomique, et
après infiltration avec la boue, l'infiltration (212) de la préforme de fibres avec une masse fondue comprenant du silicium, puis le refroidissement de la masse fondue, formant ainsi un composite à matrice céramique.

2. Procédé selon la revendication 1, dans lequel la couche barrière (106) comprend du nitrocarbure de silicium amorphe.

3. Procédé selon la revendication 2, dans lequel le nitrocarbure de silicium comporte du carbone à une concentration d'environ 0,3 % atomique à 33 % atomique et de l'azote à une concentration d'environ 30 % atomique à 60 % atomique.

4. Procédé selon l'une quelconque des revendications précédentes, dans lequel une épaisseur de la couche souple (104, 110) se situe dans une plage d'environ 0,5 micron à environ 3 microns et/ou la couche barrière (106) a un coefficient de dilatation thermique inférieur à celui des fibres de carbure de silicium (102).

5. Procédé selon l'une quelconque des revendications précédentes, dans lequel le dépôt (206) de la couche barrière (106) sur la couche souple (104, 110) comprend l'exposition de la couche souple (104, 110) à une atmosphère gazeuse comprenant :
un flux d'un gaz porteur choisi parmi N₂ et H₂,
un flux de gaz contenant du silicium, dans lequel le gaz contenant du silicium comprend de préférence en outre du carbone, particulièrement préféré, le gaz contenant du silicium comprend du méthyl-trichlorosilane (CH₃SiCl₃) et
un flux d'un gaz contenant de l'azote, dans lequel le gaz contenant de l'azote comprend de préférence de l'ammoniac, à une température comprise entre environ 700 °C et environ 1 000 °C.

6. Procédé selon l'une quelconque des revendications précédentes, une épaisseur de la couche tolérante à l'humidité (112) est d'environ 3 à environ 300 fois une épaisseur de la couche d'interface (104), et/ou la couche souple (104, 110) comprend une phase cristalline du nitrure de bore.

7. Procédé selon l'une quelconque des revendications précédentes, dans lequel le dépôt de la couche d'interface (104) comprend l'exposition des fibres de carbure de silicium (102) à une atmosphère gazeuse comprenant :
un flux d'un gaz porteur choisi parmi N₂ et H₂,
un flux d'un gaz contenant de l'azote, et un flux d'un gaz contenant du bore à une température comprise entre environ 700 °C et environ 875 °C, et
dans lequel le dépôt de la couche tolérante à l'humidité (112) comprend l'introduction d'un flux de gaz contenant du silicium dans l'atmosphère gazeuse après dépôt de la couche d'interface (104).

8. Procédé selon l'une quelconque des revendications précédentes comprenant en outre la formation de la préforme de fibres avant le revêtement des fibres de carbure de silicium (102) avec la couche souple (104, 110).

9. Préforme de fibres pour la fabrication d'un composite à matrice céramique, la préforme de fibres comprenant :
des fibres de carbure de silicium (102) revêtues d'une pluralité de couches fonctionnelles, les couches fonctionnelles comportant :
une couche souple (104, 110) comprenant du nitrure de bore, du nitrure de bore dopé au silicium et/ou du carbone pyrolytique déposée sur les fibres de carbure de silicium (102) ;
une couche barrière (106) ayant un angle de contact élevé avec du silicium fondu déposé sur la couche souple (104, 110), la couche barrière (106) ayant une épaisseur comprise entre environ 0,005 micron et environ 0,5 micron, dans laquelle la couche barrière (106) comprend du nitrocarbure de silicium ou du nitrure de silicium ;
une couche de mouillage (108) comprenant du carbure de silicium déposé sur la couche barrière (106), la couche de mouillage (108) ayant une épaisseur comprise entre 0,5 micron et environ 10 microns, dans laquelle la couche de mouillage (108) sert de couche de ri-gidification ;
dans lequel la couche souple (104, 110) comporte une couche de nitrure de bore,
une couche tolérante à l'humidité (112) comprenant du nitrure de bore dopé au silicium sur la couche de nitrure de bore, la couche de nitrure de bore étant une couche d'interface (104), la couche souple (104, 110) comprenant ainsi une structure multicouche comportant la couche tolérante à l'humidité (112) et la couche d'interface (104),
dans laquelle la couche tolérante à l'humidité (112) comporte du silicium à une concentration d'environ 2 % atomique à environ 30 % atomique.

10. Préforme de fibres selon la revendication 9, dans laquelle le nitrocarbure de silicium comporte du carbone à une concentration d'environ 0,3 % atomique à 33 % atomique et de l'azote à une concentration d'environ 30 % atomique à 60 % atomique.

11. Préforme de fibres selon l'une quelconque des revendications 9 à 10, dans laquelle une épaisseur de la couche souple (104, 110) se situe dans une plage d'environ 0,5 micron à environ 3 microns et/ou la couche barrière (106) a un coefficient de dilatation thermique inférieur à celui des fibres de carbure de silicium (102).
